# EUROPEAN PATENT SPECIFICATION

(11) **EP 3 037 196 B1**
(45) Date of publication and mention of the grant of the patent: **02.01.2019**
(21) Application number: 14838338.3
(22) Date of filing: 21.08.2014
(51) Int. Cl.: B23B 27/14, C23C 16/40, C23C 16/56, C23C 16/30, C23C 16/34, C23C 16/36

(54) **COATED CUTTING TOOL**
BESCHICHTETES SCHNEIDEWERKZEUG
OUTIL DE COUPE REVÊTU

(30) Priority: 21.08.2013 JP 2013170915
(43) Date of publication of application: 29.06.2016
(73) Proprietor: Tungaloy Corporation, Iwaki-shi Fukushima 970-1144 (JP)
(72) Inventor: SATOH, Hiroyuki, Iwaki-shi Fukushima 970-1144 (JP)
(74) Representative: Vossius & Partner Patentanwälte Rechtsanwälte mbB
(86) International application number: PCT/JP2014/071823
(87) International publication number: WO 2015/025903

(56) References cited:
- WO-A1-2009/041893
- JP-A- H0 392 204
- JP-A- H1 199 405
- JP-A- 2008 296 292

## Description

### TECHNICAL FIELD

The present invention relates to a coated cutting tool.

### BACKGROUND ART

It is conventionally known to use a coated cutting tool in which a coating layer, including a single layer of one member or multilayers of two or more members of, for example, a carbide, a nitride, a carbonitride, a carboxide, and a carboxynitride of Ti, and aluminum oxide, with a total film thickness from 3 to 20 µm is formed on a surface of a substrate made of cemented carbide by chemical vapor deposition, for cutting of steel, cast iron, and the like.

When a coating film is formed on a surface of tungsten carbide-based cemented carbide, tensile stress remains in the coating film and thus coated cutting tools are generally considered to have reduced breaking strength and be prone to break. It has been proposed to release the tensile residual stress by generating cracks with, for example, shot peening after formation of a coating film and the proposal has been quite effective (for example, see Patent Literature 1).

Further, a cutting tool that has high density cracks in a coating film in a lower portion on a substrate side and has low density cracks in the coating film in an upper portion on a surface side, is known (for example, see Patent Literature 2).

### PRIOR ART DOCUMENTS

### Patent Literature

Patent Literature 1: JP H05-116003 A
Patent Literature 2: JP H06-246512 A

US 5 123 934 A discloses a cutting tool comprising a titanium compound layer with cracks.

### DISCLOSURE OF THE INVENTION

### Problems to be solved by the Invention

In cutting process in recent years, higher speed, higher feed, and deeper cut became notable and the tool life has tended to be reduced more than conventional ones. Because of such background, when cracks are simply increased in the coating film, the fracture resistance of the tool as disclosed in Patent Literature 1 is improved. However, the tool as disclosed in Patent Literature 1 has a problem of reduction in separation resistance, chipping resistance, and wear resistance of the coating film from the cracks. The tool disclosed in Patent Literature 2 has improved wear resistance in the upper portion while it has a problem of insufficient wear resistance in the lower portion. Addition to it, it has a further problem of possibly separation in the coating film from the high density cracks in the lower portion. The present invention has been made to solve these problems, and an object of the present invention is to provide a coated cutting tool that has excellent chipping resistance, wear resistance, and fracture resistance and has long tool life by improving the mode of crack generation in the coated cutting tool.

### Means to solve the Problems

The present invention relates to a coated cutting tool according to claim 1. From the above perspective, the present inventor made intensive research on extension of tool life of coated cutting tools and has found that, with the configuration below, it is possible to improve fracture resistance without impairing chipping resistance and wear resistance, and as a result, it is possible to extend the tool life.

That is, the summary of the present invention is as follows.
(1) A coated cutting tool includes: a substrate; and a coating layer formed on a surface of the substrate, wherein
   the coating layer includes at least one layer of a Ti compound layer,
   the Ti compound layer is a compound containing a Ti element and at least one of element selected from the group consisting of C, N, O, and B,
   the Ti compound layer has a region surrounded by cracks when a polished surface approximately parallel to the surface of the substrate in the Ti compound layer is viewed from an upper surface,
   inside the region has an intermittent crack, one end or both ends of the intermittent crack not making contact with the cracks constituting the region, and
   relationship between an average number density A of the region and an average number density B of the intermittent crack satisfies 0.7 < B/A < 2.
(2) The coated cutting tool according to (1), wherein the Ti compound layer is formed on the surface of the substrate and has an average layer thickness from 2 to 20 µm.
(3) The coated cutting tool according to any of (1) or (2), wherein the coating layer has an aluminum oxide layer with an average layer thickness from 1 to 15 µm on a surface of the Ti compound layer.
(4) The coated cutting tool according to any of (1) through (3), wherein the Ti compound layer is a compound further containing at least one of element selected from the group consisting of Zr, Hf, V, Nb, Ta, Cr, Mo, W, Al, and Si.
(5) The coated cutting tool according to any of (1) through (4), wherein the aluminum oxide layer is a compound further containing at least one of element selected from the group consisting of Zr, Hf, V, Nb, Ta, Cr, Mo, W, and Si.
(6) The coated cutting tool according to any of (1) through (5), wherein the coating layer includes an outermost layer made of at least one of element selected from the group consisting of Zr, Hf, V, Nb, Ta, Cr, Mo, W, and Si and at least one member selected from the group consisting of C, N, O, and B on a surface of the aluminum oxide layer.
(7) The coated cutting tool according to any of (1) through (6), wherein the entire coating layer has a total layer thickness from 3 to 30 µm as an average layer thickness.
(8) The coated cutting tool according to any of (1) through (7), wherein the substrate is any of cemented carbide, cermet, ceramic, or sintered cubic boron nitride.

### <Coated Cutting Tool>

The coated cutting tool includes a substrate and a coating layer formed on a surface of the substrate. Specifically, examples of a type of coated cutting tool may include an indexable cutting inserts for milling or turning, drills, and end mills.

### <Substrate>

Examples of the substrate may include, for example, cemented carbide, cermet, ceramics, sintered cubic boron nitride, sintered diamond, and high speed steel. Among them, the substrate is even more preferably any of cemented carbide, cermet, ceramics, or sintered cubic boron nitride for excellent wear resistance and fracture resistance.

Such substrate may have a modified surface. The effects of the present invention are exhibited even when the surface is modified in such a manner that, for example, a β-free layer is formed on the surface for cemented carbide and a surface hardened layer may be formed for cermet.

### <Coating Layer>

The entire coating layer has a total layer thickness preferably from 3 to 30 µm as an average layer thickness. The wear resistance may be poor in the case of less than 3 µm, and the adhesion to the substrate and the fracture resistance may be reduced in the case of more than 30 µm. In the range, from 3 to 20 µm is even more preferred.

### <Ti Compound Layer>

The coating layer includes at least one layer of a Ti compound layer. The Ti compound layer means a compound layer containing a Ti element as an essential component and further containing at least one of element selected from the group consisting of C, N, O, and B. The Ti compound layer may contain at least one of element selected from the group consisting of Zr, Hf, V, Nb, Ta, Cr, Mo, W, Al, and Si as an optional component.

The Ti compound layer is preferably formed on the surface of the substrate because the adhesion between the substrate and the coating layer is improved. The Ti compound layer has an average layer thickness preferably from 2 to 20 µm. This is because the wear resistance tends to be reduced when the Ti compound layer has an average layer thickness of less than 2 µm while the fracture resistance tends to be reduced when the Ti compound layer has an average layer thickness of more than 20 µm.

In the Ti compound layer, when a polished surface approximately parallel to the surface of the substrate is viewed from an upper surface, the Ti compound layer has a region surrounded by cracks and inside the region has an intermittent crack, one end or both ends of the intermittent crack not making contact with the cracks constituting the region. Here, "viewed from an upper surface" means to view the polished surface from the approximately normal direction of the surface. In other words, it means to view from the front surface side of the coating layer, although not existing because of being polished, that is, to view from opposite side from the substrate. In addition, relationship between an average number density A of the region and an average number density B of the intermittent crack satisfies 0.7 < B/A < 2, thereby obtaining an effect of stopping cracks generated in the coating layer during cutting by the intermittent crack, so that the chipping resistance and the fracture resistance are excellent. In addition, particles in the coating layer falling during cutting are suppressed to the minimum by having the intermittent crack, and thus it is possible to maintain the wear resistance. When relationship B/A between the average number density A of the region and the average number density B of the intermittent crack is 0.7 or less, the distribution of the intermittent crack is insufficient, and thus it is not possible to obtain the effect of stopping development of cracks generated in the coating layer during cutting by the intermittent crack, so that the chipping resistance and the fracture resistance are reduced. On the other hand, when the relationship B/A between the average number density A of the region and the average number density B of the intermittent crack is 2 or more, the intermittent crack is distributed in many spots, so that the cracks constituting the region and the intermittent crack are linked easily and the fracture resistance is reduced.

The polished surface of the Ti compound layer is a surface of the Ti compound layer that is obtained by polishing the coated cutting tool approximately parallel to the surface of the substrate until the Ti compound layer is exposed. At this point, it is preferred to obtain the polished surface at a position of a layer thickness of 50% or more of the average layer thickness of the Ti compound layer. For the coated cutting tool formed with Ti compound layers of a plurality of compositions, it is preferred to measure a region of a layer of the composition with the thickest average layer thickness and the intermittent crack.

The region observed on the polished surface of the Ti compound layer is an area surrounded by cracks generated in the coating layer during cooling after the coating layer is formed and cracks produced in the coating layer by processing, such as dry blasting and shot peening. The number of regions is defined in such a manner that the smallest area surrounded by the cracks is one region. When there is an even smaller region in a region, they are defined as two regions.

It is possible to obtain the average number density of the region by the following method. The number of regions observed on the polished surface of the Ti compound layer is measured. It is possible to obtain the number density of regions by dividing the number of regions by the area of the measured Ti compound layer. It is possible to obtain the average number density by dividing the number density by the number of measured fields of view.

The intermittent crack is a crack having one end or both ends of the crack not making contact with the cracks constituting the region. Examples of the mode of intermittent crack may include, for example, a mode of not making contact with any crack in the region and a mode of developing cracks from the cracks constituting the region toward inside the region while the development is stopped without crossing the region.

It is possible to obtain the average number density of the intermittent crack by the following method. The number of intermittent crack segments observed in the polished surface of the Ti compound layer is measured. It is possible to obtain the number density of the intermittent crack by dividing the number of intermittent crack segments by the area of the measured Ti compound layer. It is possible to obtain the average number density by summing each number density of the measured fields of view and dividing the total of number densities by the number of measured fields of view.

The coating layer preferably includes an aluminum oxide layer (hereinafter, an Al₂O₃ layer) on the surface of the Ti compound layer because it is possible to suppress progress of wear due to reaction with the work piece material. The crystal system of Al₂O₃ layer is not particularly limited, and examples thereof may include α form, β form, δ form, γ form, κ form, χ form, pseudo-τ form, η form, and ρ form. Among them, the crystal system of Al₂O₃ layer is preferably α form that is stable at high temperatures or κ form that is excellent in the adhesion between the Ti compound layer and the Al₂O₃ layer. Particularly in the case that the region involved in cutting becomes high in temperature such as in high speed cutting, the Al₂O₃ layer is not easily fracture or chipping when using an α-Al₂O₃ layer. The Al₂O₃ layer preferably has an average layer thickness from 1 to 15 µm. The crater wear resistance on the rake face may be reduced when the Al₂O₃ layer has an average layer thickness of less than 1 µm, and separation easily occurs and the fracture resistance may be reduced when it has more than 15 µm.

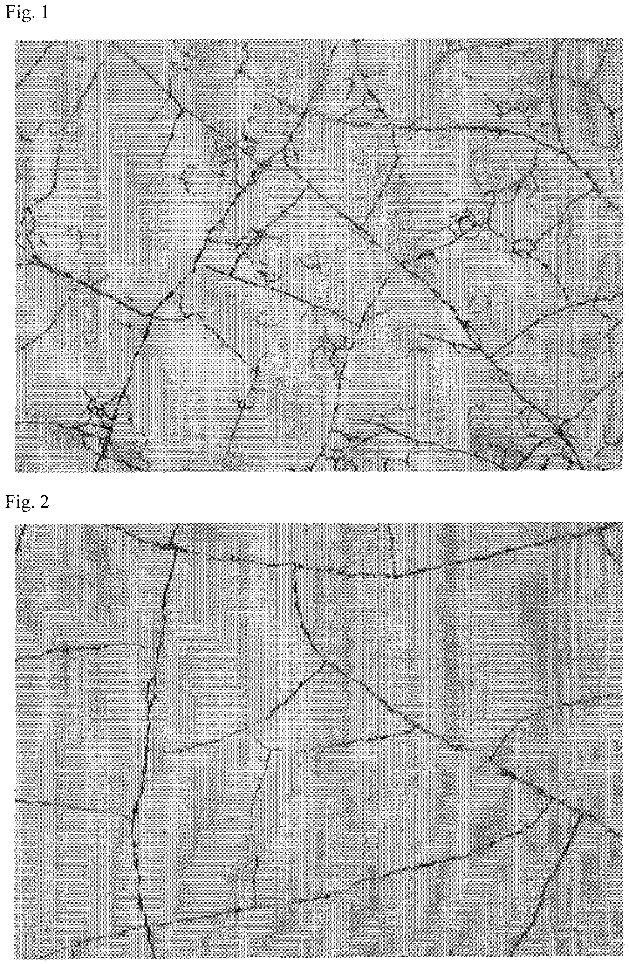

Here, Fig. 1 illustrates an example of a photograph of a polished surface in the Ti compound layer approximately parallel to the surface of the substrate viewed from an upper surface, and Fig. 2 illustrates an example of a photograph of a polished surface in a conventional Ti compound layer approximately parallel to the surface of the substrate viewed from an upper surface.

### [Method of forming coating layer]

Examples of a method of forming each layer constituting the coating layer in the coated cutting tool of the present invention may include, for example, the following method.

For example, it is possible to form a TiN layer by chemical vapor deposition in which the raw material gas composition is TiCl₄: from 5.0 to 10.0 mol%, N₂: from 20 to 60 mol%, and H₂: residual, the temperature: from 850 to 920°C, and the pressure: from 100 to 350 hPa.

It is possible to form a TiCN layer by chemical vapor deposition in which the raw material gas composition is TiCl₄: from 10 to 15 mol%, CH₃CN: from 1 to 3 mol%, N₂: from 0 to 20 mol%, and H₂: residual, the temperature: from 850 to 920°C, and the pressure: from 60 to 80 hPa.

It is possible to form a TiC layer by chemical vapor deposition in which the raw material gas composition is TiCl₄: from 1.0 to 3.0 mol%, CH₄: from 4.0 to 6.0 mol%, and H₂: residual, the temperature: from 990 to 1030°C, and the pressure: from 50 to 100 hPa.

It is possible to form an α-Al₂O₃ layer by chemical vapor deposition in which the raw material gas composition is AlCl₃: from 2.1 to 5.0 mol%, CO₂: from 2.5 to 4.0 mol%, HCl: from 2.0 to 3.0 mol%, H₂S: from 0.28 to 0.45 mol%, and H₂: residual, the temperature: from 900 to 1000°C, and the pressure: from 60 to 80 hPa.

It is possible to form a κ-Al₂O₃ layer by chemical vapor deposition in which the raw material gas composition is AlCl₃: from 2.1 to 5.0 mol%, CO₂: from 3.0 to 6.0 mol%, CO: from 3.0 to 5.5 mol%, HCl: from 3.0 to 5.0 mol%, H₂S: from 0.3 to 0.5 mol%, and H₂: residual, the temperature: from 900 to 1000°C, and the pressure: from 60 to 80 hPa.

It is possible to form a TiAlCNO layer by chemical vapor deposition in which the raw material gas composition is TiCl₄: from 3.0 to 5.0 mol%, AlCl₃: from 1.0 to 2.0 mol%, CO: from 0.4 to 1.0 mol%, N₂: from 30 to 40mol%, and H₂: residual, the temperature: from 975 to 1025°C, and the pressure: from 90 to 110 hPa.

It is possible to form a TiAlCO layer by chemical vapor deposition in which the raw material gas composition is TiCl₄: from 0.5 to 1.5 mol%, AlCl₃: from 3.0 to 5.0 mol%, CO: from 2.0 to 4.0 mol%, and H₂: residual, the temperature: from 975 to 1025°C, and the pressure: from 60 to 100 hPa.

It is possible to form a TiCNO layer by chemical vapor deposition in which the raw material gas composition is TiCl₄: from 3.0 to 5.0 mol%, CO: from 0.4 to 1.0 mol%, N₂: from 30 to 40 mol%, and H₂: residual, the temperature: from 975 to 1025°C, and the pressure: from 90 to 110 hPa.

It is possible to form a TiCO layer by chemical vapor deposition in which the raw material gas composition is TiCl₄: from 0.5 to 1.5 mol%, CO: from 2.0 to 4.0 mol%, and H₂: residual, the temperature: from 975 to 1025°C, and the pressure: from 60 to 100 hPa.

The coated cutting tool having an average number density A of the region and an average number density B of the intermittent crack satisfying 0.7 < B/A < 2 in the Ti compound layer is obtained by, for example, the following method.

It is possible to easily control the average number density B of the intermittent crack in the Ti compound layer by dry shot blasting using projectiles having a shape with an aspect ratio greater than conventional ones after the coating layer is formed. The shape of the projectiles even more preferably has a sharp convex. As the conditions of dry shot blasting, for example, the projectiles may be projected at a projection speed from 80 to 100 m/sec for a projection time from 0.5 to 1 minute to have a projection angle to the surface of the coating layer from 30 to 90°. The projectiles for dry shot blasting are preferably a material, such as Al₂O₃ and ZrO₂, having an average particle diameter from 160 to 200 µm.

It is possible to measure the layer thickness of each layer using an optical microscope, a scanning electron microscope (SEM), a field emission scanning electron microscope (FE-SEM), and the like from the sectional structure of the coated cutting tool. The layer thickness of the coated cutting tool may be obtained by measuring the layer thickness of each layer at three or more points at the positions near 50 µm from the edge toward the rake face of the coated cutting tool and obtaining an average of them. It is possible to measure the composition of each layer using an energy dispersive X-ray spectrometer (EDS), a wavelength dispersive X-ray spectrometer (WDS), and the like from the sectional structure of the coated cutting tool of the present invention.

Examples of the method of measuring the region and the intermittent crack in the Ti compound layer may include, for example, the following method. The coated cutting tool is polished in a direction approximately parallel to the surface of the substrate until the Ti compound layer is exposed to obtain a polished surface of the Ti compound layer. It is possible to easily observe cracks by etching the polished surface with fluonitric acid. The polished surface is observed at magnifications from 300 to 750 using an optical microscope to take a photograph of the polished surface. Using the photograph of the polished surface, the number of regions and the number of intermittent crack segments in the Ti compound layer are measured. It is possible to obtain the number densities of the region and the intermittent crack by dividing the measured numbers of regions and intermittent crack segments respectively by the measured area. It is possible to obtain the average number density A and the average number density B of the intermittent crack by summing the respective measured number densities of the region and the intermittent crack of each field of view and dividing them respectively by the measured number of fields of view. It is preferred to measure an area of 0.2 mm² or more using the photograph of the polished surface. When the number of regions is measured using a photograph of the polished surface, an area where it is not possible to confirm formation of a region because a crack abuts against an end of the photograph is defined as a region of 0.5.

### Effects of the Invention

The coated cutting tool of the present invention maintains the wear resistance and is excellent in the chipping resistance and the fracture resistance, and thus exhibits an effect of extending the tool life more than conventional ones.

### BRIEF DESCRIPTION OF THE DRAWINGS

Fig. 1 is an example of a photograph of a polished surface approximately parallel to the surface of the substrate viewed from an upper surface in a Ti compound layer.
Fig. 2 is an example of a photograph a polished surface approximately parallel to the surface of the substrate viewed from an upper surface in a conventional Ti compound layer.

### EXAMPLES

The present invention is described below with reference to Examples while the present invention is not limited to them.

As a substrate, a cutting insert made of cemented carbide having a shape of CNMG120412 according to JIS and composition of 86.0WC-1.0TiCN-1.3TaC-0.2NbC-0.5ZrC-11.0Co (hereinbefore, mass%) was prepared. After a cutting edge ridge of the substrate was subjected to circular honing with an SiC brush, the surface of the substrate was washed. Then, the substrate was charged into an external heating chemical vapor deposition apparatus, and a coating layer was formed on the substrate surface to have the configuration of the coating layer and the average layer thickness shown in Table 1. Ten samples were prepared for each. In Table 1, α in the crystal system of the aluminum oxide layer (Al₂O₃ layer) represents an α-Al₂O₃ layer and κ represents a κ-Al₂O₃ layer.

After the coating layer was formed, the samples thus obtained were subjected to dry shot blasting. As the conditions for dry shot blasting of Present Products 1 through 10, projectiles were projected at a projection speed of 90 m/sec for a projection time from 0.5 to 1 minute to have a projection angle to the surface of the coating layer of 45°. For the projectiles of dry shot blasting, Al₂O₃ with an average aspect ratio from 2 to 4 and an average particle diameter of 50 µm when measured at the positions of the smallest a projectile diameter was used.

Comparative Products 1 and 2 were subjected to neither dry shot blasting nor wet shot blasting.

Comparative Product 3 was subjected to dry shot blasting using steel ball projectiles having an average particle diameter of 150 µm. As the conditions for dry shot blasting, the projectiles were projected at a projection speed of 120 m/sec for a projection time of one minute to have a projection angle to the surface of the coating layer of 45°.

As the conditions for dry shot blasting of Comparative Products 4, 5, 7, and 8, projectiles were projected at a projection speed of 90 m/sec for a projection time from 0.5 to 1 minute to have a projection angle to the surface of the coating layer of 45°. For the projectiles of dry shot blasting, Al₂O₃ with an average particle diameter of 150 µm was used.

Comparative Product 6 was subjected to wet shot blasting. Projectiles were projected at a projection speed of 120 m/sec for a projection time of one minute to have a projection angle to the surface of the coating layer of 45°. For the projectiles of wet shot blasting, Al₂O₃ with an average particle diameter of 30 µm was used.

**[Table 11**

| Sample No. | Coating Layer | | | | | | | | |
|---|---|---|---|---|---|---|---|---|---|
| | Ti Compound Layer | | | | | | Aluminum Oxide Layer | | Total Layer Thickness (µm) |
| | First Layer | | Second Layer | | Third Layer | | Crystal System | Average Layer Thickness (µm) | |
| | Composition | Average Layer Thickness (µm) | Composition | Average Layer Thickness (µm) | Composition | Average Layer Thickness (µm) | | | |
| Present Product 1 | TiN | 0.3 | TiCN | 7.0 | TiCNO | 1.0 | α | 5.0 | 13.3 |
| Present Product 2 | TiN | 0.2 | TiCN | 1.5 | TiCNO | 0.3 | α | 1.0 | 3.0 |
| Present Product 3 | TiN | 1.0 | TiCN | 18.0 | TiCNO | 1.0 | α | 5.0 | 25.0 |
| Present Product 4 | TiN | 1.0 | TiCN | 13.0 | TiCNO | 1.0 | α | 15.0 | 30.0 |
| Present Product 5 | TiN | 0.3 | TiCN | 3.0 | TiCNO | 1.0 | α | 5.0 | 9.3 |
| Present Product 6 | TiN | 0.3 | TiCN | 10.0 | TiCNO | 1.0 | α | 5.0 | 16.3 |
| Present Product 7 | TiN | 0.3 | TiCN | 7.0 | TiAlCNO | 1.0 | α | 5.0 | 13.3 |
| Present Product 8 | TiN | 0.3 | TiCN | 7.0 | TiCNO | 1.0 | K | 5.0 | 13.3 |
| Present Product 9 | TiC | 0.3 | TiCN | 7.0 | TiCO | 1.0 | α | 5.0 | 13.3 |
| Present Product 10 | TiN | 0.3 | TiCN | 7.0 | TiAlCO | 1.0 | α | 5.0 | 13.3 |
| Comparative Product 1 | TiN | 0.3 | TiCN | 7.0 | TiCNO | 1.0 | α | 5.0 | 13.3 |
| Comparative Product 2 | TiN | 0.3 | TiCN | 7.0 | TiCNO | 1.0 | α | 5.0 | 13.3 |
| Comparative Product 3 | TiN | 0.3 | TiCN | 7.0 | TiCNO | 1.0 | α | 5.0 | 13.3 |
| Comparative Product 4 | TiN | 0.3 | TiCN | 7.0 | TiCNO | 1.0 | α | 5.0 | 13.3 |
| Comparative Product 5 | TiN | 0.3 | TiCN | 7.0 | TiCNO | 1.0 | α | 5.0 | 13.3 |
| Comparative Product 6 | TiN | 0.3 | TiCN | 7.0 | TiCNO | 1.0 | α | 5.0 | 13.3 |
| Comparative Product 7 | TiN | 0.2 | TiCN | 1.0 | TiCNO | 0.3 | α | 1.0 | 2.5 |
| Comparative Product 8 | TiN | 0.3 | TiCN | 20.0 | TiCNO | 0.7 | α | 10.0 | 31.0 |

The layer thickness of each layer of the samples thus obtained was obtained by measuring cross sections near the positions 50 µm from the edge of the coated cutting tool toward the central portion of the rake face at three points with an SEM and obtaining an average of them.

To measure a region and an intermittent crack in the Ti compound layer, the samples thus obtained were polished until the Ti compound layer was exposed in the direction approximately parallel to the surface of the substrate. The polished surface of the Ti compound layer was prepared to have an average layer thickness at a position 70% of the layer thickness, and the polished surface of the Ti compound was etched with fluonitric acid. The polished surface of the Ti compound layer was observed at magnifications of 300 using an optical microscope to take a photograph of the polished surface in an area of 0.33 mm². Three inserts were prepared for each sample, the number of regions and the number of intermittent crack segments in the Ti compound layer were obtained using the respective photographs of the polished surface to obtain an average number density A of the region and an average number density B of the intermittent crack in the Ti compound layer from these values. Table 2 shows the average number density A of the region and the average number density B of the intermittent crack in the Ti compound layer.

**[Table 2]**

| Sample No. | Average Number Density A in Region Surrounded by Cracks (number/mm2) | Average Number Density B of Intermittent Crack (number/mm²) | Average Number Density B of Intermittent Crack / Average Number Density A in Region Surrounded by Cracks |
|---|---|---|---|
| Present Product 1 | 917 | 1052 | 1.15 |
| Present Product 2 | 429 | 409 | 0.95 |
| Present Product 3 | 1005 | 1052 | 1.05 |
| Present Product 4 | 917 | 1052 | 1.15 |
| Present Product 5 | 520 | 393 | 0.76 |
| Present Product 6 | 610 | 1209 | 1.98 |
| Present Product 7 | 864 | 991 | 1.15 |
| Present Product 8 | 766 | 853 | 1.11 |
| Present Product 9 | 808 | 796 | 0.99 |
| Present Product 10 | 784 | 934 | 1.19 |
| Comparative Product 1 | 155 | 32 | 0.21 |
| Comparative Product 2 | 320 | 54 | 0.17 |
| Comparative Product 3 | 972 | 375 | 0.39 |
| Comparative Product 4 | 446 | 268 | 0.60 |
| Comparative Product 5 | 671 | 1399 | 2.08 |
| Comparative Product 6 | 336 | 78 | 0.23 |
| Comparative Product 7 | 415 | 264 | 0.64 |
| Comparative Product 8 | 792 | 1647 | 2.08 |

Using the samples thus obtained, First Cutting Test and Second Cutting Test were performed. Processing distances until tool life are shown in Table 3. First Cutting Test is a test to evaluate the wear resistance and Second Cutting Test is one to evaluate the fracture resistance.

### [First Cutting Test]

Work piece material: S45C round bar,
Cutting speed: 250 m/min,
Feed: 0.30 mm/rev,
Depth of cut: 2.0 mm,
Coolant: Used,
Point of evaluation: Processing time until tool life was measured where the tool life was defined as the time when the sample was fracture or had a maximum width of flank wear reaching 0.2 mm.

### [Second Cutting Test]

Work piece material: S45C round bar with two longitudinal grooves at equal interval,
Cutting speed: 200 m/min,
Feed: 0.40 mm/rev,
Depth of cut: 1.5 mm,
Coolant: Used,
Point of evaluation: The number of impacts until tool life was measured where the tool life was defined as the time when the sample was fracture. The number of impacts was defined as the number that the work piece material made contact with the sample, and the test was terminated when the number of contact reached 20000 times at maximum. Five inserts were prepared for each sample, and the respective number of impacts was measured to obtain an average from the values of these numbers of impacts to define as the tool life.

**[Table 3]**

| Sample No. | First Cutting Test | | Second Cutting Test | |
|---|---|---|---|---|
| | Wear Test | | Breaking Test | |
| | Tool Life (min) | Mode of Damage | Tool Life (times) | Mode of Damage |
| Present Product 1 | 42 | Normal Wear | 20000 | Normal Wear |
| Present Product 2 | 26 | Normal Wear | 16200 | Fracture |
| Present Product 3 | 38 | Normal Wear | 18900 | Fracture |
| Present Product 4 | 35 | Normal Wear | 18000 | Fracture |
| Present Product 5 | 25 | Normal Wear | 16500 | Fracture |
| Present Product 6 | 29 | Normal Wear | 16900 | Fracture |
| Present Product 7 | 41 | Normal Wear | 20000 | Normal Wear |
| Present Product 8 | 39 | Normal Wear | 20000 | Normal Wear |
| Present Product 9 | 34 | Normal Wear | 17800 | Fracture |
| Present Product 10 | 40 | Normal Wear | 18200 | Fracture |
| Comparative Product 1 | 20 | Fracture | 3600 | Fracture |
| Comparative Product 2 | 18 | Fracture | 3200 | Fracture |
| Comparative Product 3 | 32 | Normal Wear | 8900 | Fracture |
| Comparative Product 4 | 21 | Chipping | 5600 | Fracture |
| Comparative Product 5 | 22 | Chipping | 6000 | Fracture |
| Comparative Product 6 | 26 | Normal Wear | 4300 | Fracture |
| Comparative Product 7 | 15 | Chipping | 5100 | Fracture |
| Comparative Product 8 | 18 | Chipping | 5400 | Fracture |

As shown in Table 3, it was found that the wear resistance, the chipping resistance, and the fracture resistance were improved, thereby the processing time until tool life was longer and the number of impacts was more in Present Products than in Comparative Products, so that the tool life was significantly longer.

## Claims

1. A coated cutting tool, comprising: a substrate; and a coating layer formed on a surface of the substrate, wherein
the coating layer includes at least one layer of a Ti compound layer,
the Ti compound layer is a compound containing a Ti element and at least one element selected from the group consisting of C, N, O, and B,
the Ti compound layer has a region that is a smallest area surrounded by cracks when a polished surface approximately parallel to the surface of the substrate in the Ti compound layer is viewed from approximately normal direction of the polished surface,
inside the region has an intermittent crack, one end or both ends of the intermittent crack not making contact with the cracks constituting the region, and
relationship between an average number density A of the region and an average number density B of the intermittent crack satisfies 0.7 < B/A < 2;
the number density A of the region is a number obtained by dividing the number of regions in a measured fields of view by the area of the measured fields of view, and
the number density B of the intermittent crack is a number obtained by dividing the number of the intermittent cracks in a measured fields of view by the area of the measured fields of view.

2. The coated cutting tool according to claim 1, wherein the Ti compound layer is formed on the surface of the substrate and has an average layer thickness from 2 to 20 µm.

3. The coated cutting tool according to any one of claim 1 or 2, wherein the coating layer has an aluminum oxide layer with an average layer thickness from 1 to 15 µm on a surface of the Ti compound layer.

4. The coated cutting tool according to claim 3, wherein
the aluminum oxide layer is a compound further containing at least one element selected from the group consisting of Zr, Hf, V, Nb, Ta, Cr, Mo, W, and Si.

5. The coated cutting tool according to claim 3 or 4, wherein the coating layer includes the aluminum oxide layer and an outermost layer made of at least one element selected from the group consisting of Zr, Hf, V, Nb, Ta, Cr, Mo, W, and Si and at least one member selected from the group consisting of C, N, O, and B on a surface of the aluminum oxide layer.

6. The coated cutting tool according to any one of claims 1 through 5, wherein the Ti compound layer is a compound further containing at least one element selected from the group consisting of Zr, Hf, V, Nb, Ta, Cr, Mo, W, Al, and Si.

7. The coated cutting tool according to any one of claims 1 through 6, wherein the entire coating layer has a total layer thickness from 3 to 30 µm as an average layer thickness.

8. The coated cutting tool according to any one of claims 1 through 7, wherein the substrate is any of cemented carbide, cermet, ceramic, or sintered cubic boron nitride.

## Patentansprüche

1. Beschichtetes Schneidwerkzeug, das aufweist: ein Substrat; und eine Überzugsschicht, die auf einer Oberfläche des Substrats ausgebildet ist, wobei
die Überzugsschicht mindestens eine Schicht einer Ti-Verbindungsschicht aufweist,
die Ti-Verbindungsschicht eine Verbindung ist, die ein Ti-Element und mindestens ein Element enthält, das aus der Gruppe ausgewählt ist, die aus C, N, O und B besteht,
die Ti-Verbindungsschicht einen Bereich aufweist, der eine kleinste Fläche ist, die durch Risse umgeben ist, wenn eine polierte Oberfläche, die annähernd parallel zur Oberfläche des Substrats in der Ti-Verbindungsschicht ist, aus einer annähernd normalen Richtung der polierten Oberfläche betrachtet wird,
innerhalb des Bereichs ein intermittierender Riss vorhanden ist, wobei ein Ende oder beide Enden des intermittierenden Risses keinen Kontakt mit den Rissen aufnehmen, die den Bereich bilden, und
eine Beziehung zwischen einer durchschnittlichen Anzahldichte A des Bereichs und einer durchschnittlichen Anzahldichte B des intermittierenden Risses 0,7 < B/A < 2 erfüllt;
die Anzahldichte A des Bereichs eine Anzahl ist, die durch Dividieren der Anzahl der Bereiche in einem Messfeld durch die Fläche der Messfelder erhalten wird, und
die Anzahldichte B des intermittierenden Risses eine Anzahl ist, die durch Dividieren der Anzahl der intermittierenden Risse in einem Messfeld durch die Fläche der Messfelder erhalten wird.

2. Beschichtetes Schneidwerkzeug nach Anspruch 1, wobei die Ti-Verbindungsschicht auf der Oberfläche des Substrats ausgebildet ist und eine durchschnittliche Schichtdicke von 2 bis 20 µm aufweist.

3. Beschichtetes Schneidwerkzeug nach Anspruch 1 oder 2, wobei die Überzugsschicht eine Aluminiumoxidschicht mit einer durchschnittlichen Schichtdicke von 1 bis 15 µm auf einer Oberfläche der Ti-Verbindungsschicht aufweist.

4. Beschichtetes Schneidwerkzeug nach Anspruch 3, wobei die Aluminiumoxidschicht eine Verbindung ist, die ferner mindestens ein Element enthält, das aus der Gruppe ausgewählt ist, die aus Zr, Hf, V, Nb, Ta, Cr, Mo, W und Si besteht.

5. Beschichtetes Schneidwerkzeug nach Anspruch 3 oder 4, wobei die Überzugsschicht die Aluminiumoxidschicht und eine äußerste Schicht auf einer Oberfläche der Aluminiumoxidschicht aufweist, die aus mindestens einem Element, das aus der Gruppe ausgewählt ist, die aus Zr, Hf, V, Nb, Ta, Cr, Mo, W und Si besteht, und mindestens einem Element gebildet ist, das aus der Gruppe ausgewählt ist, die aus C, N, O und B besteht.

6. Beschichtetes Schneidwerkzeug nach einem der Ansprüche 1 bis 5, wobei die Ti-Verbindungsschicht eine Verbindung ist, die ferner mindestens ein Element enthält, das aus der Gruppe ausgewählt ist, die aus Zr, Hf, V, Nb, Ta, Cr, Mo, W, Al und Si besteht.

7. Beschichtetes Schneidwerkzeug nach einem der Ansprüche 1 bis 6, wobei die gesamte Überzugsschicht eine Gesamtschichtdicke von 3 bis 30 µm als eine durchschnittliche Schichtdicke aufweist.

8. Beschichtetes Schneidwerkzeug nach einem der Ansprüche 1 bis 7, wobei das Substrat aus irgendeinem von Hartmetall, Cermet, Keramik oder gesintertem kubischen Bornitrid besteht.

## Revendications

1. Outil de coupe revêtu, comprenant : un substrat ; et une couche de revêtement formée sur une surface du substrat, où
la couche de revêtement comprend au moins une couche de composé de Ti,
la couche de composé de Ti est un composé contenant un élément de titane et au moins un élément sélectionné dans le groupe comprenant C, N, O et B,
la couche de composé de Ti présente une région qui est une surface minimale entourée de fissures quand une surface polie sensiblement parallèle à la surface du substrat dans la couche de composé de Ti est vue dans une direction sensiblement normale à la surface polie,
la région présente intérieurement une fissure intermittente, une extrémité ou les deux extrémités de ladite fissure intermittente n'étant pas en contact avec les fissures constituant la région, et
la relation entre un nombre volumique moyen A de la région et un nombre volumique moyen B de la fissure intermittente satisfait à 0,7 <B/A< 2 ;
le nombre volumique A de la région est un nombre obtenu par division du nombre de régions dans un champ de vision mesuré par la surface du champ de vision mesuré, et
le nombre volumique B de la fissure intermittente est un nombre obtenu par division du nombre de fissures intermittentes dans un champ de vision mesuré par la surface du champ de vision mesuré.

2. Outil de coupe revêtu selon la revendication 1, où la couche de composé de Ti est formée sur la surface du substrat et a une épaisseur de couche moyenne comprise entre 2 et 20 µm.

3. Outil de coupe revêtu selon la revendication 1 ou la revendication 2, où la couche de revêtement comprend une couche d'oxyde d'aluminium avec une épaisseur de couche moyenne comprise entre 1 et 15 µm sur une surface de la couche de composé de Ti.

4. Outil de coupe revêtu selon la revendication 3, où
la couche d'oxyde d'aluminium est un composé contenant en outre au moins un élément sélectionné dans le groupe comprenant Zr, Hf, V, Nb, Ta, Cr, Mo, W et Si.

5. Outil de coupe revêtu selon la revendication 3 ou la revendication 4, où la couche de revêtement comprend la couche d'oxyde d'aluminium et une couche extérieure constituée d'au moins un élément sélectionné dans le groupe comprenant Zr, Hf, V, Nb, Ta, Cr, Mo, W et Si, et au moins un élément sélectionné dans le groupe comprenant C, N,O et B sur une surface de la couche d'oxyde d'aluminium.

6. Outil de coupe revêtu selon l'une des revendications 1 à 5, où la couche de composé de Ti est un composé contenant en outre au moins un élément sélectionné dans le groupe comprenant Zr, Hf, V, Nb, Ta, Cr, Mo, W, Al et Si.

7. Outil de coupe revêtu selon l'une des revendications 1 à 6, où toute la couche de revêtement a une épaisseur de couche totale comprise entre 3 et 30 µm en tant qu'épaisseur de couche moyenne.

8. Outil de coupe revêtu selon l'une des revendications 1 à 7, où le substrat est du carbure cémenté, ou du cermet, ou une céramique, ou du nitrure de bore cubique fritté.
